# EUROPEAN PATENT APPLICATION

(11) **EP 4 312 469 A1**
(43) Date of publication of application: **31.01.2024**
(21) Application number: 22186633.8
(22) Date of filing: 25.07.2022
(51) Int. Cl.: H05G 2/00

(54) **DROPLET GENERATOR NOZZLE**

(71) Applicant: ASML Netherlands B.V., 5500 AH Veldhoven (NL)
(72) Inventor: VAN DRENT, William, Peter, 5500 AH Veldhoven (NL)
(74) Representative: ASML Netherlands B.V.

(57) **Abstract**

A nozzle is provided for a droplet generator for a laser-produced plasma radiation source. The nozzle comprises a glass capillary 210 for emitting droplets and a nozzle fitting 220 comprising a throughbore 240, wherein the glass capillary is at least partially disposed in the throughbore. The nozzle further comprises a glass ferrule 250 coupling the glass capillary to the nozzle fitting, the glass ferrule being conformed to a shape of the throughbore of the nozzle fitting. A method of manufacturing a nozzle for a droplet generator is also provided.

## Description

### FIELD

The present invention relates to a nozzle for a droplet generator for a laser-produced plasma radiation source, and to methods for manufacturing the nozzle.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern from a patterning device (e.g., a mask) onto a layer of radiation-sensitive material such as photoresist, or simply resist, provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength greater that 4-20 nm.

EUV radiation may be produced using a plasma. A radiation system for producing EUV radiation may include a laser for exciting a fuel to provide the plasma, and a source collector module for containing the plasma. The plasma may be created, for example, by directing a laser beam at a fuel, such as particles of a suitable material (e.g. tin (Sn)), or a stream of a suitable gas or vapor, such as Xe gas or Li vapor. The resulting plasma emits output radiation, e.g., EUV radiation, which is collected using a radiation collector. The radiation collector may be a mirrored normal incidence radiation collector, which receives the radiation and focuses the radiation into a beam. The source collector module may include an enclosing structure or chamber arranged to provide a vacuum environment to support the plasma. Such a radiation system is typically termed a laser produced plasma (LPP) source.

The fuel may be directed toward a path of the laser beam by a droplet generator. The droplet generator can include a nozzle to emit the fuel as droplets. Such a nozzle may operate in a pressurized and/or high temperature environment, and as such, it may be necessary to form temperature and pressure resistant seals (e.g. hermetic seals) between components of the nozzle. Existing nozzles may comprise seals between components which suffer from poor reliability, stability and performance.

A prior art nozzle assembly 100 is depicted in Fig. 1. The nozzle 100 is an example of the nozzles disclosed in WO2021/074043 A1, which is incorporated herein by reference. The nozzle 100 comprises a glass capillary 110 for emitting droplets of fuel from a fuel emitter. The fuel emitter may be a droplet generator.

The glass capillary 110 is coupled to a nozzle fitting 120, which may be integral with or coupled to the fuel emitter. The fitting 120 may comprise metal, and thus may be termed a metal fitting.

It is necessary to form a seal, e.g. a hermetic seal, between the glass capillary 110 and the fitting 120. To this end, the glass capillary 110 is at least partially disposed within a throughbore 140 of the fitting 120. The fitting 120 is heated, and a pressure is applied to the glass capillary 110 such that the glass capillary 110 conforms to the shape of, and forms a direct glass-to-metal seal with, the throughbore 140. In this way a seal is formed between the fitting 120 and the capillary 110.

However, by design this approach deforms the glass capillary 110 to contact the metal fitting 120. Such deformation may not be reproducible. Therefore properties of the glass capillary 110 such as the transfer function, resonance properties (base frequency), strength, and the glass-to-metal seal may not be reproducible. The transfer function is the ratio of the velocity modulation of the droplets exiting the nozzle and the actuation force applied to the nozzle. The transfer function is preferably high at the base modulation frequency (e.g. between 50 and 200 kHz). This transfer function depends on geometric aspects of the glass capillary 110, including length and diameter. Therefore it is undesirable that the manufacturing process changes such geometric parameters. Furthermore, bubbles and/or high stress locations can develop during the deformation and cooling process, potentially weakening the end product.

### SUMMARY

It is an object of the present disclosure to provide nozzles for droplet generators with seals between the glass capillary and the fitting that overcome one or more of deficiencies of known nozzles.

According to an aspect of the invention, there is provided a nozzle for a droplet generator for a laser-produced plasma radiation source, the nozzle comprising: a glass capillary for emitting droplets; a nozzle fitting comprising a throughbore, wherein the glass capillary is at least partially disposed in the throughbore; and a glass ferrule coupling the glass capillary to the nozzle fitting, the glass ferrule being conformed to a shape of the throughbore of the nozzle fitting.

Advantageously, such a nozzle allows the glass capillary to retain its original strength and shape as much as possible, limiting the structural and reproducibility issues discussed above. Instead of deforming the glass capillary, a glass ferrule couples the glass capillary to the nozzle fitting. The glass ferrule can deform under heating to provide a secure seal, including providing a direct metal-to-glass seal where the nozzle fitting is a metal fitting, without affecting the properties of the glass capillary. Furthermore, the ferrule material can be optimised for the function of bonding, providing improved seals and/or improving the manufacturing process. For example ferrule materials may be selected that soften at lower temperatures than the glass capillary material, reducing the energy required to manufacture the nozzle. Thus the softening temperature/firing temperature of the glass ferrule may be lower than the softening temperature/firing temperature glass capillary, so that the capillary does not substantially soften during the bonding process. The softening temperature of the glass ferrule is still higher than a maximum operating temperature of the nozzle/the system for which the nozzle is designed. For example the softening temperature may be above 300°C, or above 400°C, or above 500°C.

In some embodiments, a coefficient of thermal expansion of the glass capillary is substantially the same as, or less than, or more than, a coefficient of thermal expansion of the nozzle fitting. In particular, the coefficient of thermal expansion (CTE) of the glass capillary may be within 1 PPM/K, or within 0.5 PPM/K, or within 0.3 PPM/K of the coefficient of thermal expansion of the nozzle fitting. Alternatively or additionally, the coefficient of thermal expansion of the glass ferrule may be within 1 PPM/K, or within 0.5 PPM/K of the coefficient of thermal expansion of the nozzle fitting. As used herein, having a CTE within a value of the CTE of the nozzle fitting may comprise having a CTE either higher or lower than the CTE of the nozzle fitting. The coefficient of thermal expansion may be a coefficient of thermal expansion over a temperature range comprising an operational temperature of the nozzle and/or a manufacturing temperature range of the nozzle. Such embodiments may limit cracking and defects due to different expansion and contraction properties of the component of the nozzle as the nozzle is heated and cooled in manufacture and in use.

In some embodiments, the glass ferrule has a lower softening and/or firing temperature than the glass capillary. This means that the glass ferrule deforms (when heated) whilst the glass capillary retains its original solid properties during manufacture of the nozzle.

According to a further aspect of the invention, there is provided a method of manufacturing a nozzle for a droplet generator. The method comprises positioning a glass capillary in a throughbore of a nozzle fitting; positioning a glass ferrule preform around the glass capillary; and heating the glass ferrule preform to form a glass ferrule coupling the glass capillary to the nozzle fitting.

In some embodiments, positioning the glass ferrule preform comprises positioning the glass ferrule preform in the throughbore of the nozzle fitting. A force may be applied to push the glass ferrule preform into the throughbore, for example using either a pusher and/or a weight.

In alternative embodiments, positioning the glass ferrule preform comprises positioning the glass ferrule preform at an end of the throughbore. The glass ferrule preform is then heated such that it flows into the throughbore to form the glass ferrule. In particular, the glass capillary may be positioned in the throughbore with a gap between the glass capillary and a wall of the throughbore such that, upon heating, the glass ferrule preform flows into the gap by capillary action.

### BRIEF DESCRIPTION OF FIGURES

The above and other aspects of the present disclosure will become more apparent from the description of exemplary embodiments, taken in conjunction with the accompanying drawings.
Fig. 1 depicts an example of a conventional nozzle for a droplet generator for a laser-produced plasma radiation source.
Fig. 2 depicts a lithographic system comprising a lithographic apparatus and a radiation source and embodying a droplet generator.
Fig. 3 depicts a nozzle for a droplet generator.
Figs. 4a-e depict alternative examples of the nozzle of Fig. 3.
Fig. 5 depicts an example of a droplet generator incorporating a nozzle.
Fig. 6 illustrates a method of manufacturing a nozzle.
Fig. 7 depicts an example of the method in which a glass ferrule preform is forced into position.
Figs. 8a and 8b depict an alternative example of the method in which a glass ferrule preform is flowed into a gap between a throughbore of a nozzle fitting and a glass capillary.

The figures are schematic. The schematic diagrams and views show the components described below. However, the components depicted in the figures are not to scale. Relative dimensions of components in drawings are exaggerated for clarity. Within the following description of drawings the same or like reference numbers refer to the same or like components or entities, and only the differences with respect to the individual embodiments are described.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

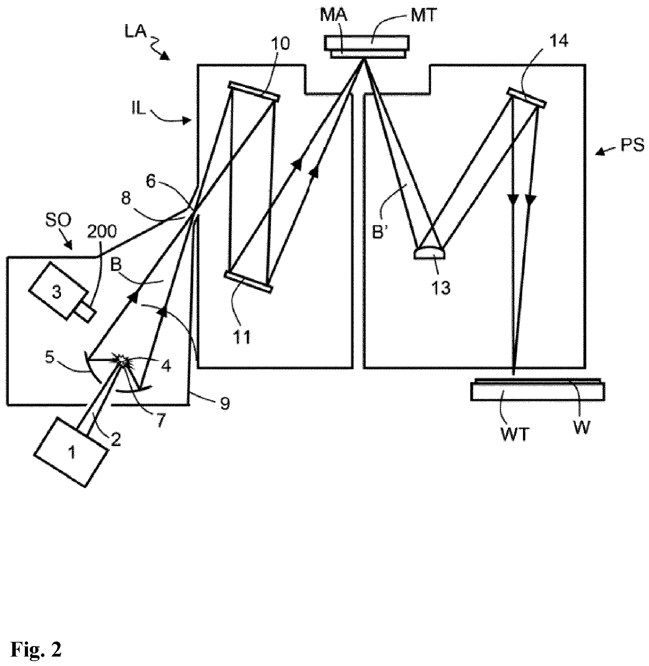

Fig. 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IE, a support structure MT configured to support a patterning device MA (e.g., a mask or reticle), a projection system PS and a substrate table WT configured to support a substrate W.

The illumination system IE is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Fig. 2, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO shown in Fig. 2 is, for example, of a type which may be referred to as a laser produced plasma (LPP) source. A laser system 1, which may, for example, include a C02 laser, is arranged to deposit energy via a laser beam 2 into a fuel, such as tin (Sn) which is provided from, e.g., a fuel emitter 3 (an example of a droplet generator). Although tin is referred to in the following description, any suitable fuel may be used. The fuel may, for example, be in liquid form, and may, for example, be a metal or alloy. The fuel emitter 3 comprises a nozzle 200 configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IE. The radiation source SO is arranged such that the intermediate focus 6 is located at or near to an opening 8 in an enclosing structure 9 of the radiation source SO.

Although Fig. 2 depicts the radiation source SO as a laser produced plasma (LPP) source, any suitable source such as a discharge produced plasma (DPP) source or a free electron laser (EEL) may be used to generate EUV radiation.

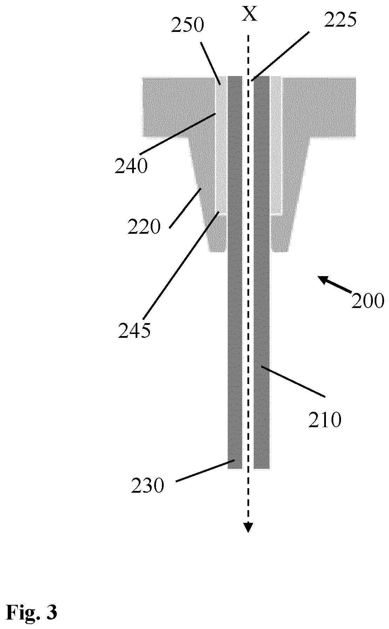

As described above, the fuel emitter 3 may comprise a nozzle 200 configured to direct fuel, e.g. tin in the form of droplets, along a trajectory towards a plasma formation region 4. Fig. 3 illustrates an example of a nozzle according to the present disclosure.

The nozzle 200 shown in Fig. 3 is a nozzle for a droplet generator. The droplet generator may be the fuel emitter 3 discussed above, for example. The nozzle 200 comprises a glass capillary 210 for emitting droplets. The glass capillary 210 is a hollow glass tube, open at a first end 225 and at a second end 230. In use, fuel enters the first end 225, and travels along the length of the glass capillary 210 (along the axis X) to the second end 230, from where it is emitted as a droplet.

The glass capillary 210 may comprise a borosilicate, an aluminosilicate or quartz. The glass capillary 210 may comprise soda-lime glass, or alkali barium glass. The glass capillary 210 may comprise an alkali barium aluminoborosilicate glass. The glass capillary 210 may be optimized or modified, such as by mixing of alkali (Na and K) and/or alkaline earth (Ca and Mg), or the like, to achieve required physico-chemical properties.

The glass capillary 210 may be a straight tube with substantially constant inner and outer diameters, at least for a portion of the glass capillary disposed in a nozzle fitting 230.

Also shown in Fig. 3 is a nozzle fitting 220. The nozzle fitting 220 is attached to or is attachable to the droplet generator (e.g. fuel emitter 3), or generally system which the nozzle 200 is intended to be used in. For example, the nozzle fitting 220 may be integral with or coupled to the droplet generator. The nozzle fitting 220 includes a throughbore 240. In the illustrated example, the throughbore 240 is substantially straight, and may be a uniform cylinder. As discussed further below, the throughbore 240 and nozzle fitting 220 may take other forms. The glass capillary 210 is disposed in the throughbore 240 of the nozzle fitting 220. In the illustrated example, the glass capillary 210 protrudes from a lower end (further along the X axis) of the nozzle fitting 220. That is, the second end 230 is not disposed in the throughbore 240. The first end 225 of the glass capillary 210 is flush with an upper end (earlier along the X axis) of the nozzle fitting 220. In other examples, either or both ends 225, 230 of the glass capillary may be flush with an end of the nozzle fitting 220, or may protrude from the respective end of the nozzle fitting 220.

The nozzle fitting 220 may be formed of or comprise a metal. In such cases the nozzle fitting may be referred to as a metal fitting 220. In particular examples, the nozzle fitting 220 is formed of or comprises molybdenum, tantalum, tungsten, and/or niobium, for example. In some embodiments, the nozzle fitting 220 may comprise, for example, aluminum and/or platinum. In some embodiments, the nozzle fitting 220 may be formed of or comprise a metal alloy, such as stainless steel, TZM (molybdenum titanium), Tungsten, Tantalum, Niobium. The nozzle fitting may be formed of or comprise any alloy of molybdenum and tungsten, for example MoW50 (50% Mo and 50% W), MoW30 (30% W). The nozzle fitting 220 may be formed of or comprise an alloy of tungsten and tantalum (for example WTa10 with 10% tantalum), or any other alloys of the metals listed above. The nozzle fitting 220 may comprise a metal oxide. For example, the nozzle fitting may comprise a layer of metal oxide. The layer of metal oxide may have a thickness of 1 nm or more, or 10 nm or more, or 100 nm or more. Alternatively or additionally the layer of metal oxide may have a thickness of 5 µm or less, or 1 µm or less, or 100 µm or less. The layer of metal oxide may cover only part of the nozzle fitting 220, such as the throughbore 240 or a part thereof. In still other examples the nozzle fitting 220 is formed of a metal oxide, a ceramic, or a glass.

At least a portion of the nozzle fitting 220 may advantageously comprise an oxide layer on surface that forms the throughbore 240. Such an oxide layer may provide a more robust and/or reliable and/or effective glass-to-metal seal. Beneficially, the provision of an oxide layer, e.g. a metal-oxide layer, provides oxygen atoms that may be used to form an effective glass-to-metal bond layer.

It will be appreciated that the provision of a metal-oxide layer is applicable to any metal used to form a glass-to-metal seal. For example, a nozzle fitting 220 comprising any of molybdenum, tungsten, tantalum, and/or a metal alloys such as a nickel-cobalt ferrous alloy, may comprise a metal oxide layer. In some example embodiments, at least a portion of the nozzle fitting 220, e.g. at least a portion of the throughbore 240 of the nozzle fitting, may be oxidized to ensure an adequate and/or sufficient oxide layer is present prior to forming the glass-to-metal seal.

Should such an oxide layer be desired but found to be initially absent, or insufficient, the nozzle fitting 220 may be treated to form an oxide layer. For example, the nozzle fitting 220 may be heated in the presence of oxygen to accelerate formation of such an oxide layer.

It is advantageous that a coefficient of thermal expansion (CTE) of the nozzle fitting 220 is substantially the same as, or within a predefined range relative to, a CTE of the glass capillary 210. In particular the CTE may be an operational temperature range of the nozzle. The operational temperature range may depend upon the fuel emitted or ejected by the nozzle 200. For example, the operational temperature range for liquid tin as a fuel may be approximately 300 K to 530 K. Approximately matching the CTE of the glass capillary 210 and the nozzle fitting 220 limits the potential for damage to occur during heating and cooling of the nozzle 200 due to different expansion/contraction properties of the glass capillary 210 and the nozzle fitting 220.

Furthermore, it is also advantageous that a CTE of the nozzle fitting 220 is substantially the same as, or within a predefined range relative to, a CTE of the glass capillary 210 over a temperature range which includes temperatures required to manufacture the nozzle 200, discussed further below. As such, it is advantageous that a CTE of the nozzle fitting 220 is substantially the same as, or within a predefined range relative to, a CTE of the glass capillary 210 over an entire temperature range that includes the temperatures reached during manufacture, and preferably also an operational temperature range of the nozzle 200, which may comprise temperatures less than room temperature. To this end, in some examples a coefficient of thermal expansion of the glass capillary 210 is within ±1 PPM/K, or within ±0.5 PPM/K, or within ±0.3 PPM/K of the coefficient of thermal expansion of the nozzle fitting 220 (i.e. the CTE of the glass capillary 210 may be above or below the CTE of the nozzle fitting 220, as long as the CTEs are within the given range). The CTE may be CTE at operational and/or manufacturing temperatures. The CTE of the glass capillary 210 and nozzle fitting may generally be 10 PPM/K or less, or 8 PPM/K or less, or 7 PPM/K or less.

For example, a nozzle fitting 220 comprising molybdenum may have a CTE of approximately 5.5 ppm/K. As such, a predefined range for the CTE of a glass capillary 210 may be, for example, +/-0.5 ppm/K relative to the nozzle fitting 220 CTE. Various borosilicate or aluminosilicate glasses comprise a CTE matched to within +/- 0.5 ppm/K to molybdenum.

Furthermore, in use a fuel provided by the droplet generator may be, for example a tin compound, e.g., SnBr4, SnBr2, SnH4, or a tin alloy, e.g., tin-gallium alloys, tin-indium alloys, tin-indium-gallium alloys, or a combination thereof. Depending on the material used, the target material may be provided by the droplet generator at various temperatures including room temperature or near room temperature (e.g., tin alloys, SnBr4), at an elevated temperature, (e.g., pure tin) or at temperatures below room temperature, (e.g., SnH4). Thus, it is particularly beneficial for the glass capillary 210 and the nozzle fitting 220 to have relative dimensions that are temperature invariant in terms of its performance across an entire operational temperature range.

By closely matching a CTE of the glass capillary 210 to the CTE of the nozzle fitting 220, cracking of the glass capillary after heating-up the nozzle to a working temperature, e.g. 250 to 500 K for molten tin, may be avoided.

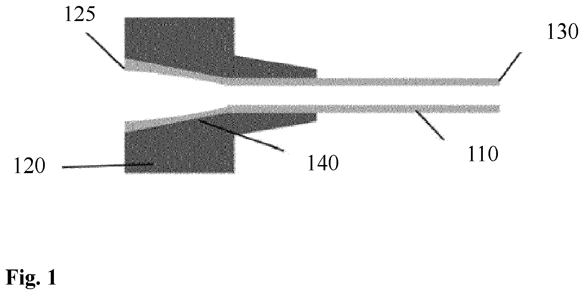

As shown in Fig. 3, the nozzle 200 further comprises a glass ferrule 250. The glass ferrule 250 couples the glass capillary 210 to the nozzle fitting 220. The glass ferrule 250 conforms to a shape of the throughbore 240 of the nozzle fitting 220. Thus in contrast to the prior art example shown in Fig. 1, the nozzle 200 comprises an additional component in the form of the glass ferrule 250 to attach the glass capillary 210 to the nozzle fitting 220. The glass ferrule 250 is deformed to conform to the shape of the throughbore 240, rather than deforming the glass capillary 210. This allows a direct glass-to-fitting seal (e.g. direct glass-to-metal where the nozzle fitting is a metal fitting) to be used, without the disadvantages of deforming the glass capillary 210 discussed above. The glass ferrule 250 forms a glass-to-metal seal with the nozzle fitting 220, and a glass-to-glass seal with the glass capillary 210. The glass ferrule 250 can be considered a solder glass connecting the nozzle fitting 250 to the glass capillary 210. Solder glasses, and particular examples of solder glasses that may be used to form the glass ferrule 250, are discussed in R. G. Frieser, "A Review of Solder Glasses", Electrocomponent Science and Technology, 1975, Vol. 2, pp 163-169, which is incorporated herein by reference.

The glass ferrule 250 is formed of a material that deforms in preference to the glass capillary 210. For example, the glass ferrule 250 may have a lower softening and/or firing temperature than the glass capillary. By heating the glass ferrule 250 to a temperature above its softening temperature, but below the softening temperature of the glass capillary 210, the glass ferrule 250 can be made to conform to the throughbore 240 without damaging the glass capillary 210. The softening temperature or firing temperature of the glass ferrule 250 may for example be 50K or more, or 100K or more, or 150K or more, or 200K or more lower than the corresponding temperature of the glass capillary 210.

The glass ferrule 250 may have a coefficient of thermal expansion (CTE) that is substantially equal to or lower than a CTE of the nozzle fitting 220 and/or CTE of the glass capillary 210. In some examples, the coefficient of thermal expansion of the glass ferrule 250 is within ±1 PPM/K, or within ±0.5 PPM/K of the coefficient of thermal expansion of the nozzle fitting 220 and/or of the coefficient of thermal expansion of the glass capillary 210 (i.e. the CTE of the glass ferrule may be above or below the CTE of the nozzle fitting and/or glass capillary 210, as long as the CTEs are within the given range). As with the CTE of the glass capillary 210 discussed above, approximately matching the CTE of the glass ferrule 250 to that of the other components can reduce failures due to different expansion and contraction properties. However, the for glass ferrule 250 in particular, it has been found that it is advantageous for the CTE to be lower than that of the nozzle fitting 220 and the glass capillary 210, though still within the ranges of the other CTEs listed above. However, in the case of thin glass ferrules 250 discussed below, for example formed by capillary action, the ferrule 250 may be sufficiently thin that thermally generated expansion or contraction is negligible. The expansion of the glass ferrule 250 is then not likely a factor in failure of the seal, and so glasses with any CTE may be used for the glass ferrule 250.

In some examples, the glass ferrule 250 is formed of a glass with a coefficient of thermal expansion of 2PPM/K or more, or 3 PPM/K or more, or 4 PPM/K or more. Alternatively or additionally the glass ferrule 250 may be formed of a glass with a coefficient of thermal expansion of 6PPM/K or less, or 7PPM/K or less, or 8PPM/K or less. Preferably the coefficient of thermal expansion of the glass ferrule 250 is in the range from 3.5 to 7 PPM/K. Further preferably, the CTE of the glass ferrule is within 0.5 PPM/K of the CTE of the glass capillary 210. Additionally, the glass ferrule 250 preferably has a softening temperature in the range 500°C to 900°C.

The material of the glass ferrule 250 should be resistant to the fuel the nozzle 200 is intended to handle. For example, where the nozzle 200 emits tin droplets, the material of the glass ferrule 250 should be resistant to tin.

In some examples, the glass ferrule 250 is formed of or comprises a borosilicate, an aluminosilicate, a borofluorophosphate, or a borovanadate glass. In some examples the glass ferrule 250 is formed of a mixture of materials. For example, the glass ferrule 250 may comprise solid particles added into the glass, such as metal particles, oxide particles, or ceramic particles. Adding such particles can provide a number of advantages. Firstly, by adding particles of materials of very low CTE, the average CTE of the resulting glass mixture can be lowered. This provides additional flexibility in choosing the glass material whilst still allowing the CTE of the glass ferrule 250 to be matched to other components. Secondly, by choosing the dimensions of the particles, a minimum spacing can be ensured for the capillary layer. This can help in centering the glass capillary 210 in the nozzle fitting 220. Thirdly, the particles can assist in crack arresting, making the material more stress resistant.

In the example illustrated in Fig. 3, the glass ferrule 250 is shown as being relatively thick. This may be the case for example where the glass ferrule 250 is formed from a preformed tube placed around the glass capillary 210 within the throughbore 240, which is then heated to conform to the shape of the throughbore 240. The thickness of the glass ferrule 250 may be 1mm or less, or 0.7mm or less, or 0.5mm or less. The thickness of the glass ferrule may be 0.3mm or more, or 0.5mm or more. The thickness may be in the range from 0.3mm to 0.7mm. As used herein, the thickness of the glass ferrule 250 means the thickness of a wall of the glass ferrule 250 between a wall of the throughbore 240 and an outer wall of the glass capillary 210.

In other examples, a thinner glass ferrule 250 may be used. In this case a glass may be flowed into a narrow space between the glass capillary 210 and the wall of the throughbore 240 to form the glass ferrule 250. Thus in some examples the glass ferrule may have a thickness of 0.2mm or less, and/or 0.1 mm or more. In some examples a diameter of the glass capillary 210 and a diameter of the throughbore 240 creates a spacing between the glass capillary 210 and nozzle fitting 220 such that, when softened, glass of the glass ferrule 250 flows by capillary action. In some examples, the spacing between the glass capillary 210 and nozzle fitting 220 is 10µm or more, or 15µm or more, or 20µm or more. Alternatively or additionally, the spacing may be 30µm or less, or 25µm or less, or 20µm or less. In a preferred example, the spacing is in the range from 15µm to 25µm. Here, the spacing may be an average spacing, for example where the spacing various at different points between the glass capillary 210 and the nozzle fitting 220.

It is noted that in such examples where thinner glass ferrules 250 are used, the CTE of the glass ferrule 250 itself may not have a significant impact on the stability of the nozzle 200. The expansion of the thin material in such examples is small compared to the expansion of the nozzle fitting 220 and the glass capillary 210. Thus only the CTE of nozzle fitting 220 and glass capillary 210 may be matched (as discussed above). This allows more choice of material for the glass ferrule 250 as CTE of the glass ferrule 250 is not a factor is choice of material. For example, the glass ferrule 250 material may be selected to optimise properties such as softening/firing temperature, wetting, and/or capillary action.

In the example illustrated in Fig. 3, the glass ferrule 250 extends through only a portion of the throughbore 240. The glass ferrule 250 of this example is flush at one end with the upper end of the throughbore 240. The throughbore 240 is shaped to provide a lip 245 for limiting the extension of the glass ferrule 250 further along the throughbore 240. Thus for example a glass ferrule preform may be pushed into the throughbore 240 from the upper end of the throughbore 240, and will be stopped by the lip 245 to correctly position the glass ferrule within the throughbore 240. In this example the lip 245 is towards the droplet exit end of the throughbore 240, but in other examples may towards the liquid supply inlet side of the throughbore 240 (e.g. where the ferrule 240 is inserted from the droplet exit end). Further, in the illustrated example the portion of the throughbore 240 through which the glass ferrule 240 is substantially cylindrical. However, in other examples the glass ferrule 250 extends to different extents through the throughbore 240, and the throughbore 240 can have different shapes.

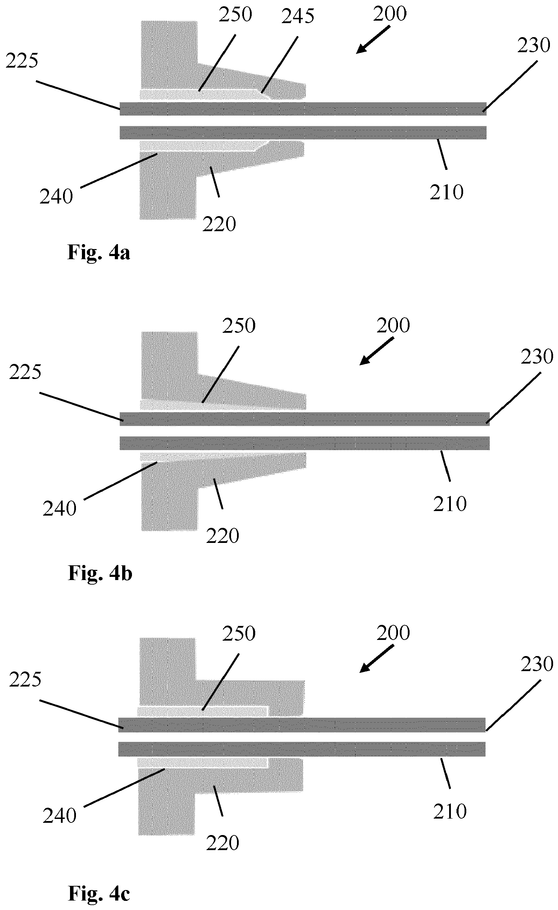

Figs 4A to 4E illustrate some examples of alternative forms of the nozzle 200.

In Fig. 4A, the first end 225 of the glass capillary 210 is no longer flush with the upper end of the throughbore 240, but instead extends beyond the upper end. Additionally, the lip 245 of the throughbore 240 is wedge-shaped. The lip 245 tapers from a maximum diameter of the throughbore 240 to a minimum diameter of the throughbore 240, the latter in the portion of the throughbore 240 into which the glass ferrule 250 does not extend. The end of the glass ferrule 250 that mates with the lip 245 is similarly wedge-shaped.

In Fig. 4B, the throughbore 240 is substantially frustum-shaped. That is, the throughbore 240 has a substantially conical-shaped surface. The diameter of the throughbore 240 tapers from the upper end of the throughbore 240 to the lower end of the throughbore 240. Such a frustum/conical shape may be, for example, formed by machining the nozzle fitting 220 with a conical reamer. The glass ferrule 250 conforms to the shape of the throughbore 250, and so is also substantially frustum-shaped. In this example, the glass ferrule 250 extends the full length of the throughbore 240. In other examples the glass ferrule 250 may extend only partially through the throughbore 240. In such examples, only a portion of the throughbore 240 (the portion into which the glass ferrule 250 extends) may be substantially frustum-shaped.

The nozzle fittings 220 illustrated in Figs. 3, 4A, and 4B have had an outer shape that is partially frustum-shaped. However, the outer shape of the nozzle fitting 220 may take any form. In particular, the outer shape of the nozzle fitting may be configured for fitting into a droplet generator 3. Fig. 4C shows an example of a nozzle 220 with a different outer form. In this case, the nozzle fitting 220 has a substantially cylindrical outer portion. In other examples, the outer shape (or a portion thereof) may be cuboidal, or any other shape.

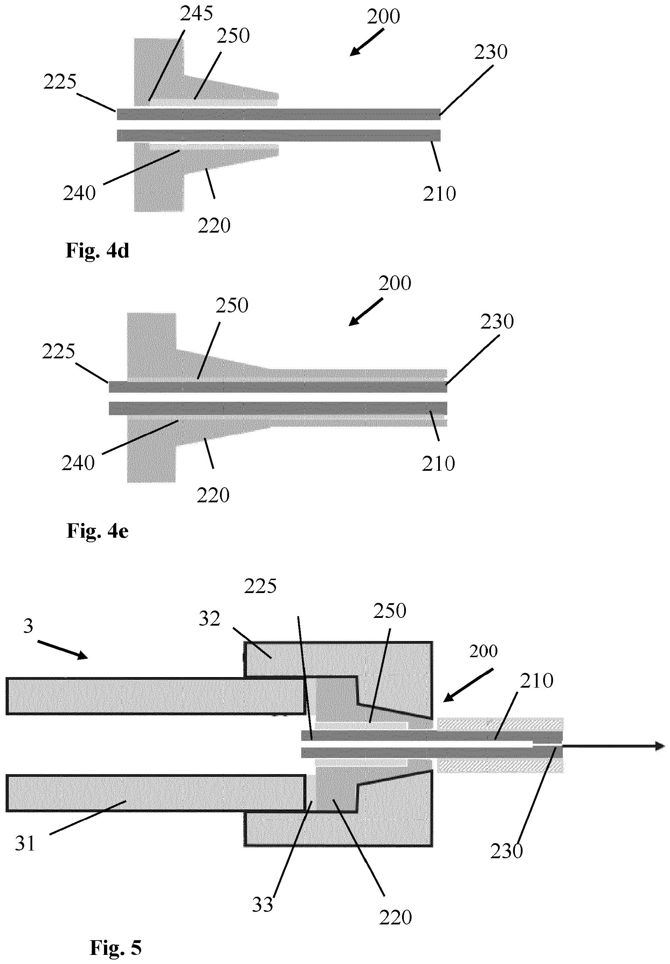

In the nozzles 200 discussed so far, the glass ferrule 250 has extended from an upper end of the throughbore 240 (i.e. the end where fuel is introduced to the nozzle 200). However, any of the examples discussed herein can instead have a glass ferrule 250 extending from the lower end of the throughbore 240 (i.e. the opposite end to the upper end). Fig. 4D shows such a nozzle 200. This nozzle 200 is substantially similar to that shown in Fig. 3, except that the glass ferrule 250 extends from the lower end of the throughbore 240 to a lip 245.

Fig. 4E illustrates a further example of a nozzle 200 in which the glass ferrule 250 extends fully through the throughbore 240. In this example the throughbore 240 is substantially cylindrically shaped.

Fig. 5 shows an example of a nozzle 200 coupled to a droplet generator 3. The droplet generator 3 may be a fuel emitter 3 as discussed above in relation to Fig. 2. The droplet generator 3 comprises a body 31 to which the nozzle 200 is attached. A nut couples the body 31 to the nozzle 200. In particular, the nut extends around at least an upper portion of the nozzle fitting 220 to secure the nozzle 200 to the body 3. A seal 33 is provided between an upper surface of the nozzle fitting 220 and the body 3. In use, fuel is provided via the body 31 to the first end 225 of the glass capillary 210. The fuel passes through the glass capillary 210 to the send end 230, where it is emitted as droplets. As shown in Fig. 5, the second end 230 of the glass capillary 210 may be configured to emit droplets. For example, as shown, the second end 230 may be shaped to provide a narrow opening through which droplets exit the glass capillary 210.

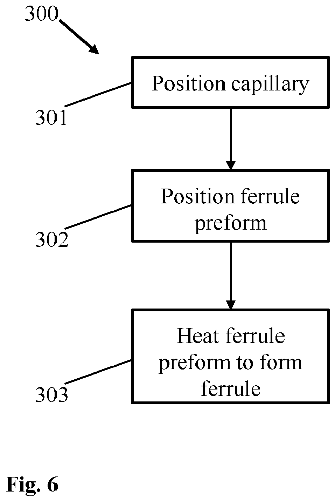

Fig. 6 illustrates a method 300 of manufacturing a nozzle 200 for a droplet generator 3. The method 300 may be used to manufacture any of the nozzles 200 discussed above.

Method 300 starts at 301, at which a glass capillary 210 is positioned in a throughbore 240 of a nozzle fitting 220. An outer diameter of the glass capillary 210 is slightly smaller than an internal diameter of the throughbore 240. As such, the glass capillary 210 can be inserted into the throughbore 240. For example, a difference between the outer diameter of the glass capillary 210 and the internal diameter of the throughbore 240 may be in the region of 1mm, 0.1mm, or less but other differences in the respective diameters may be used in other embodiments. The properties of the glass capillary 210, nozzle fitting 220, and throughbore 240 may be the same as those discussed above.

With the glass capillary 210 in place, method 300 proceeds to 302, at which a glass ferrule preform 400 is positioned around the glass capillary 210. The glass ferrule preform is the same material as the glass ferrule 250 discussed above, but has not yet been shaped to conform to the shape of the throughbore 240. It is noted that in some examples, 302 and 301 of method 300 are reversed. In other words, the glass ferrule preform 400 is positioned around the glass capillary 210, and then the glass capillary 210 (and preform 400) is positioned in the throughbore 240.

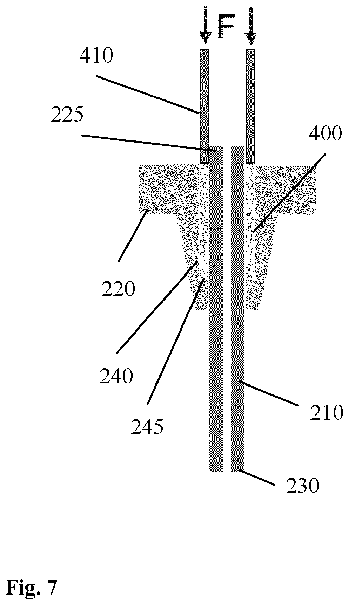

Fig. 7 illustrates an example of positioning a glass ferrule preform 400 which may be used in method 300. In this example, positioning the glass ferrule preform 400 comprises positioning the glass ferrule preform 400 in the throughbore 240 of the nozzle fitting. The glass ferrule preform 400 may be positioned such that it is fully within the throughbore 240. In this example the glass ferrule preform 400 is positioned approximately at the location where the glass ferrule 250 is intended to be positioned. The glass ferrule preform 400 may be inserted into the throughbore 240 by initially positioning the glass ferrule preform at an end of the throughbore 240 (here the upper end), and applying a force, F, to push the glass ferrule preform into the throughbore. In the illustrated example a pusher 410 is used to push the glass ferrule preform 400 into the throughbore 240. The pusher 240 may be formed of or comprise graphite. In other examples gravity may be used to push the glass ferrule preform 400 into the throughbore 240. For example, one or more weights may be placed on an upper end of the glass ferrule preform 400 (or pusher 410) such that gravity forces the glass ferrule into the throughbore.

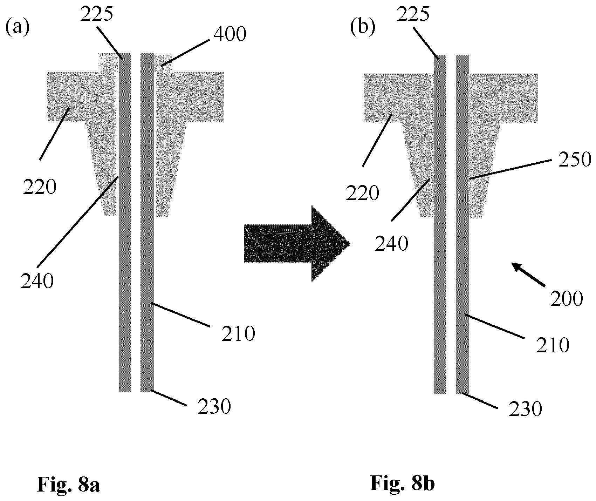

Fig. 8a illustrates an alternative example of positioning a glass ferrule preform 400, which may be used in 302 of method 300. In this example, the glass ferrule preform 400 is a ring of material placed at the upper end of the throughbore 240. It is to be appreciated that in other examples the glass ferrule preform 400 may be placed at the lower end of the throughbore 240 (i.e. the end through which in use fuel exits). In such cases the nozzle fitting 220 may be rotated for the manufacturing step such that the lower end of the throughbore 240 as defined above is gravitationally above the upper end.

Upon heating (discussed further in relation to method 300 below), the glass ferrule preform of Fig. 8a softens and flows into the throughbore 240. When cooled, this forms a glass ferrule 250 coupling the nozzle fitting 220 to the glass capillary 210, as shown in Fig. 8b. In particularly advantageous embodiments, the glass capillary 210 is positioned in the throughbore with a gap between the glass capillary 210 and a wall of the throughbore 240 such that, upon heating, the glass ferrule preform 400 flows into the gap by capillary action.

Although shown in Fig. 8b as extending fully through the throughbore 240, it will be appreciated that in other examples the glass ferrule preform 400 may be flowed only partially through the throughbore 240. For example the throughbore 240 may comprise a lip 245, as discussed above, preventing further flow of the glass ferrule preform 400 along the throughbore 240.

In some examples, the glass ferrule preform 400 may comprise a glass powder interspersed with a polymer. Such a glass ferrule preform 400 may be manufactured by compressing glass particles and heating so that the polymer binder binds the glass particles together into the desired shape. Such a glass ferrule preform 400 is then positioned around the glass capillary 210, for example using the approach illustrated in Fig. 7. Once in position, the glass ferrule preform 400 is heated to remove the polymer from the preform 400. This may be part of the heating to deform the preform 400 discussed further below, or may be an initial heating step, heating to a lower temperature to remove the polymer prior to heating to a higher temperature to deform the preform 400.

Having positioned the glass ferrule preform 400, method 300 proceeds to 303. At 303, the glass ferrule preform 400 is heated to form a glass ferrule 250 coupling the glass capillary 210 to the nozzle fitting 220.

Heating of the glass ferrule preform 400 may comprise disposing the nozzle fitting 220, glass capillary 210, and glass ferrule preform 400 in an temperature controlled oven or chamber, such as a vacuum oven. Heating may comprise induction heating the nozzle fitting 220. By heating the nozzle fitting 220 by means of induction, the glass ferrule preform 400 may be heated by the nozzle fitting 220. Heating using a vacuum oven may be particularly advantageous, as it may allow batch processing of nozzles 200, and provide an inert environment to prevent oxidation of the heated components.

The glass ferrule preform 400 may be heated to a temperature above a softening temperature of the glass ferrule preform 400, but below a softening temperature of the glass capillary. The glass ferrule preform 400 may be heated to a temperature of 500°C or more, or 650°C or more. The glass capillary preform 400 may be heated to a temperature of 800°C or less, or 750°C or less. Such temperatures are readily achievable in a vacuum over.

By heating the glass ferrule preform 400 above its softening temperature, the glass ferrule preform 400 transitions from a rigid state to a softened state, e.g. a relatively pliable or partially melted state. That is, the glass ferrule preform 400 may be heated, either directly or by the nozzle fitting 220, until a viscosity of the glass that forms the glass ferrule preform 400 is reduced to an extent that the glass becomes relatively pliable. For examples such as that in Fig. 7, where the glass ferrule preform 400 is placed substantially at the intended final position of the glass ferrule 250, the viscosity of the glass may only need to be reduced such that it conforms to the shape of the throughbore. In examples such as that in Fig. 8a, a lower viscosity may be needed to allow the material to flow into and along the throughbore 240.

In some examples, heating is performed in a relatively inert atmosphere or a vacuum. For example, the nozzle 200 may be disposed within a shroud, vessel, chamber, enclosure or the like, and exposed to a relatively inert gas such as nitrogen or argon. A gas mixture containing hydrogen may also be used, such as forming gas (approximately 98% Ar and 2% H₂). Beneficially, such a relatively inert gas may prevent oxidation of one or more surface of the glass ferrule 250, the glass capillary 210 or nozzle fitting 220. For example, a nozzle fitting 220 comprising molybdenum may be particularly subject to oxidation when heated in the presence of oxygen. In the case of hydrogen-containing mixtures, the hydrogen may reduce the surface of refractory metals such as Mo or W-based metals, removing oxygen from their surface. Thus, heating the nozzle fitting 220 in the presence of a relatively inert gas may prevent, or at least minimize, such oxidation on a surface of the nozzle fitting 220 and/or glass capillary 210 where an oxide layer is undesired. For example, it may be desirable to have an oxide layer present only on a portion of a surface of the nozzle fitting 220 that forms the glass-to-metal seal.

In some examples, a gas may be flowed through the glass capillary 210 during heating. The gas may be an inert gas such as argon. This may prevent oxidation of the inner surface of the glass capillary 210. The gas is flowed at a low pressure that does not deform the glass capillary 210.

A further step in the method 300 of manufacturing the nozzle 200 for a droplet generator may comprise cooling the nozzle 200. Such cooling may be active cooling, e.g. by refrigeration or by means of a cooled gas flow, or by natural cooling, e.g. leaving the components to cool down to an ambient temperature. Such cooling may follow or adhere to a pre-defined temperature profile. Beneficially, such cooling may at least partially anneal the glass ferrule 250 and/or glass capillary 210, thus reducing internal stresses within the glass components.

The method may comprise a step of annealing the glass ferrule 250 and/or glass capillary 210. The particular temperatures and/or heating and/or cooling rates required for annealing of the glass capillary 210 may depend upon the particular glass type and/or composition of glass. For example, the glass capillary 210 may be heated to approximately 600K to 800K, before cooling to an ambient temperature, but other temperatures can also be used in other embodiments. Such an annealing step may be repeated one or more times.

In some examples the method 300 further comprises forming a nozzle outlet in the second end 230 of the glass capillary 200. The nozzle outlet may be configured to emit droplets. Forming the nozzle outlet may comprise heating and/or machining the second end 230 to shape the outlet as desired, for example to provide a narrow opening from which droplets are emitted.

As used herein, the term "glass-to-metal" seal refers to a seal, e.g. a hermetic seal between a glass and a metal, wherein the metal is construed as comprising a metal, a metal alloy, and/or a metal oxide. That is, the term "glass-to-metal seal" should be understood to comprise a seal between a glass and a metal, wherein the metal may comprise an oxide layer. For example, in a particular embodiment of the present disclosure, wherein the nozzle fitting 220 comprises molybdenum, the term "glass-to-metal seal" includes a seal between the glass ferrule 250 and a surface of the nozzle fitting 220, wherein prior to the seal being formed a surface of the nozzle fitting 220 that is to be sealed to the glass ferrule 250 may have comprised an oxide layer.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference has been made above to the use of embodiments of the invention in the context of a droplet generator for a laser-produced plasma radiation source, it will be appreciated that a nozzle manufactured according to the claimed and described method(s) may find utility and/or be suitable for use in a variety of other applications. For example, such a nozzle may be generally applicable to any fluid conveyance application, and in particular any fluid conveyance application wherein the fluid to be conveyed is under pressure.

Although specific reference may have been made above to the use of embodiments of the invention in the context of optical lithography, it will be appreciated that the invention, where the context allows, is not limited to optical lithography and may be used in other applications, for example imprint lithography.

Other aspects of the invention are set out in the following numbered clauses.
1. A nozzle for a droplet generator for a laser-produced plasma radiation source, the nozzle comprising:
   a glass capillary for emitting droplets;
   a nozzle fitting comprising a throughbore, wherein the glass capillary is at least partially disposed in the throughbore; and
   a glass ferrule coupling the glass capillary to the nozzle fitting, the glass ferrule being conformed to a shape of the throughbore of the nozzle fitting.
2. The nozzle of clause 1, wherein a coefficient of thermal expansion of the glass capillary is within 1 PPM/K, or within 0.5 PPM/K, or within 0.3 PPM/K of the coefficient of thermal expansion of the nozzle fitting.
3. The nozzle of clause 1 or clause 2, wherein the coefficient of thermal expansion of the glass ferrule is within 1 PPM/K, or within 0.5 PPM/K of the coefficient of thermal expansion of the nozzle fitting.
4. The nozzle of any of clauses 1 to 3, wherein the coefficient of thermal expansion of the glass ferrule is less than the coefficient of thermal expansion of the nozzle fitting and less than the coefficient of thermal expansion of the glass capillary.
5. The nozzle of any preceding clause, wherein the glass ferrule has a lower softening temperature than the glass capillary.
6. The nozzle of any preceding clauses, wherein the glass ferrule has been coupled to the glass capillary and nozzle fitting by positioning a glass ferrule preform in the throughbore and heating the glass ferrule preform.
7. The nozzle of any of clauses 1-5, wherein the glass ferrule has been coupled to the glass capillary and nozzle fitting by flowing a glass ferrule preform into the throughbore by capillary action.
8. The nozzle of any preceding clause, wherein the glass ferrule has a thickness of 1mm or less, or 0.7mm or less, or 0.5mm or less, or 0.2mm or less.
9. The nozzle of any preceding clause, wherein the glass ferrule has a thickness of 0.1mm or more, or 0.3mm or more, or 0.5mm or more.
10. The nozzle of any preceding clause, wherein the glass ferrule has a thickness in the range 0.3mm to 0.7mm, or a thickness in the range 0.1mm to 0.2mm.
11. The nozzle of any preceding clause, wherein a diameter of the glass capillary and a diameter of the throughbore creates a spacing between the glass capillary and nozzle fitting such that, when softened, glass of the glass ferrule flows by capillary action.
12. The nozzle of any preceding clause, wherein the glass ferrule extends a full length of the throughbore.
13. The nozzle of any of clauses 1-11, wherein the glass ferrule extends a partial length of the throughbore.
14. The nozzle of clause 13, wherein the throughbore is shaped to provide a lip for limiting the extension of the glass ferrule along the throughbore.
15. The nozzle of any of preceding clause, wherein the glass capillary protrudes from one or both ends of the throughbore.
16. The nozzle of any preceding clause, wherein an end of the glass capillary is flush with an end of the throughbore.
17. The nozzle of any preceding clause, wherein the nozzle fitting comprises molybdenum, tantalum, tungsten, or a metal alloy.
18. The nozzle of any preceding clause, wherein the nozzle fitting comprises a metal oxide layer.
19. The nozzle of any preceding clause, wherein the glass capillary comprises a borosilicate, an aluminosilicate, or quartz.
20. The nozzle of any preceding clause, wherein the glass ferrule comprises a borosilicate, an aluminosilicate, a borofluorophosphate, or a borovanadate.
21. A method of manufacturing a nozzle for a droplet generator, the method comprising:
   positioning a glass capillary in a throughbore of a nozzle fitting;
   positioning a glass ferrule preform around the glass capillary;
   heating the glass ferrule preform to form a glass ferrule coupling the glass capillary to the nozzle fitting.
22. The method of clause 21, wherein positioning the glass ferrule preform comprises positioning the glass ferrule preform in the throughbore of the nozzle fitting.
23. The method of clause 22, comprising applying a force to push the glass ferrule preform into the throughbore.
24. The method of clause 23, wherein applying a force comprises using a pusher to push the glass ferrule preform into the throughbore.
25. The method of clause 23 or clause 24, comprising applying a weight to the glass ferrule preform and/or pusher, such that gravity forces the glass ferrule into the throughbore.
26. The method of clause 21, wherein positioning the glass ferrule preform comprises positioning the glass ferrule preform at an end of the throughbore, and wherein the glass ferrule preform is heated such that it flows into the throughbore to form the glass ferrule.
27. The method of any of clauses 21 to 26, wherein the glass capillary is positioned in the throughbore with a gap between the glass capillary and a wall of the throughbore such that, upon heating, the glass ferrule preform flows into the gap by capillary action.
28. The method of clause 27, wherein the gap has a thickness of 0.2mm or less and/or wherein the gap has a thickness of 0.1mm or more.
29. The method of any of clauses 21 to 28, wherein the glass capillary preform is heated using an induction heater configured to heat the nozzle fitting.
30. The method of any of clauses 21 to 29, wherein the glass capillary preform is heated using a vacuum oven.
31. The method of any of clauses 21 to 30, wherein the glass ferrule preform is heated to a temperature above a softening temperature of the glass ferrule preform, but below a softening temperature of the glass capillary.
32. The method of any of clauses 21 to 31, wherein the glass capillary preform is heated to a temperature of 500°C or more, or 650°C or more.
33. The method of any of clauses 21 to 32, wherein the glass capillary preform is heated to a temperature of 800°C or less, or 750°C or less.
34. The method of any of clauses 21 to 33, further comprising flowing a gas through the glass capillary.
35. The method of any of clauses 21 to 34, further comprising forming a nozzle outlet in an end of the glass capillary.
36. The method of any of clauses 21 to 35, wherein a coefficient of thermal expansion of the glass capillary is within 1 PPM/K, or within 0.5 PPM/K, or within 0.3 PPM/K of the coefficient of thermal expansion of the nozzle fitting.
37. The method of any of clauses 21 to 36, wherein the coefficient of thermal expansion of the glass ferrule is within 1 PPM/K, or within 0.5 PPM/K of the coefficient of thermal expansion of the nozzle fitting.
38. The method of any of clauses 21 to 37, wherein the coefficient of thermal expansion of the glass ferrule is less than the coefficient of thermal expansion of the nozzle fitting and less than the coefficient of thermal expansion of the glass capillary.
39. The method of any one of clauses 21 to 38, wherein the glass ferrule, when formed, extends a full length of the throughbore.
40. The method of any one of clauses 21 to 38, wherein the glass ferrule, when formed, extends a partial length of the throughbore.
41. The method of any one of clauses 1 to 40, wherein the throughbore is shaped to provide a lip for limiting the extension of the glass ferrule along the throughbore.
42. The method of any one of clauses 21 to 41, wherein the glass capillary is positioned in the throughbore such that it protrudes from one or both ends of the throughbore.
43. The method of any one of clauses 21 to 42, wherein the glass capillary is positioned in the throughbore such that an end of the glass capillary is flush with an end of the throughbore.
44. The method of any one of clauses 21 to 43, wherein the nozzle fitting comprises molybdenum, tantalum, tungsten, or a metal alloy.
45. The method of any one of clauses 21 to 44, wherein the nozzle fitting comprises a metal oxide layer.
46. The method of any one of clauses 21 to 45, wherein the glass capillary comprises a borosilicate, an aluminosilicate, or quartz.
47. The method of any one of clauses 21 to 46, wherein the glass ferrule preform comprises a borosilicate, an aluminosilicate, a borofluorophosphate, or a borovanadate.
48. A droplet generator for a laser-produced plasma radiation source, the droplet generator comprising a nozzle according to any one of clauses 1 to 20.
49. A lithographic system comprising a radiation source, the radiation source comprising a droplet generator according to clause 48.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

## Claims

1. A nozzle for a droplet generator for a laser-produced plasma radiation source, the nozzle comprising:
a glass capillary for emitting droplets;
a nozzle fitting comprising a throughbore, wherein the glass capillary is at least partially disposed in the throughbore; and
a glass ferrule coupling the glass capillary to the nozzle fitting, the glass ferrule being conformed to a shape of the throughbore of the nozzle fitting.

2. The nozzle of claim 1, wherein a coefficient of thermal expansion of the glass capillary is within 1 PPM/K, or within 0.5 PPM/K, or within 0.3 PPM/K of the coefficient of thermal expansion of the nozzle fitting; and/or
wherein the coefficient of thermal expansion of the glass ferrule is within 1 PPM/K, or within 0.5 PPM/K of the coefficient of thermal expansion of the nozzle fitting.

3. The nozzle of claim 1 or claim 2, wherein the coefficient of thermal expansion of the glass ferrule is less than the coefficient of thermal expansion of the nozzle fitting and less than the coefficient of thermal expansion of the glass capillary.

4. The nozzle of any preceding claim, wherein the glass ferrule has a lower softening temperature than the glass capillary.

5. The nozzle of any preceding claim, wherein the glass ferrule has a thickness of 1mm or less, or 0.7mm or less, or 0.5mm or less, or 0.2mm or less; and/or
wherein the glass ferrule has a thickness of 0.1mm or more, or 0.3mm or more, or 0.5mm or more.

6. The nozzle of any preceding claim, wherein a diameter of the glass capillary and a diameter of the throughbore creates a spacing between the glass capillary and nozzle fitting such that, when softened, glass of the glass ferrule flows by capillary action.

7. The nozzle of any preceding claim, wherein the throughbore is shaped to provide a lip for limiting the extension of the glass ferrule along the throughbore.

8. The nozzle of any preceding claim, wherein:
the nozzle fitting comprises molybdenum, tantalum, tungsten, or a metal alloy; and/or
the glass capillary comprises a borosilicate, an aluminosilicate, or quartz; and/or
the glass ferrule comprises a borosilicate, an aluminosilicate, a borofluorophosphate, or a borovanadate.

9. A method of manufacturing a nozzle for a droplet generator, the method comprising:
positioning a glass capillary in a throughbore of a nozzle fitting;
positioning a glass ferrule preform around the glass capillary; and
heating the glass ferrule preform to form a glass ferrule coupling the glass capillary to the nozzle fitting.

10. The method of claim 9, wherein positioning the glass ferrule preform comprises positioning the glass ferrule preform in the throughbore of the nozzle fitting.

11. The method of claim 10, comprising applying a force to push the glass ferrule preform into the throughbore.

12. The method of claim 11, comprising applying a weight to the glass ferrule preform and/or pusher, such that gravity forces the glass ferrule into the throughbore.

13. The method of claim 9, wherein positioning the glass ferrule preform comprises positioning the glass ferrule preform at an end of the throughbore, and wherein the glass ferrule preform is heated such that it flows into the throughbore to form the glass ferrule.

14. The method of any of claims 9 to 13, wherein the glass capillary is positioned in the throughbore with a gap between the glass capillary and a wall of the throughbore such that, upon heating, the glass ferrule preform flows into the gap by capillary action.

15. The method of any of claims 9 to 14, wherein the glass ferrule preform is heated to a temperature above a softening temperature of the glass ferrule preform, but below a softening temperature of the glass capillary.
